(19) Europäisches Patentamt
European Patent Office
Office européen des brevets

(11) **EP 2 980 268 B1**

(12) **EUROPEAN PATENT SPECIFICATION**

(45) Date of publication and mention
of the grant of the patent:
**02.06.2021 Bulletin 2021/22**

(51) Int Cl.:
*C23C 14/34* $^{(2006.01)}$     *B22D 13/02* $^{(2006.01)}$
*C22C 9/00* $^{(2006.01)}$     *B22D 11/00* $^{(2006.01)}$
*B22D 21/02* $^{(2006.01)}$     *C23C 14/06* $^{(2006.01)}$

(21) Application number: **14773134.3**

(22) Date of filing: **27.03.2014**

(86) International application number:
**PCT/JP2014/058867**

(87) International publication number:
**WO 2014/157519 (02.10.2014 Gazette 2014/40)**

(54) **CYLINDRICAL SPUTTERING TARGET AND PROCESS FOR PRODUCING SAME**

ZYLINDERFÖRMIGES SPUTTERTARGET UND VERFAHREN ZUR HERSTELLUNG DAVON

CIBLE DE PULVÉRISATION CYLINDRIQUE ET SON PROCÉDÉ DE PRODUCTION

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **29.03.2013 JP 2013071195
20.11.2013 JP 2013240056**

(43) Date of publication of application:
**03.02.2016 Bulletin 2016/05**

(73) Proprietor: **Mitsubishi Materials Corporation
Chiyoda-ku
Tokyo 100-8117 (JP)**

(72) Inventors:
• **KATO Shinji
Sanda-shi
Hyogo 669-1339 (JP)**
• **ZHANG Shoubin
Sanda-shi
Hyogo 669-1339 (JP)**
• **KOMIYAMA Shozo
Sanda-shi
Hyogo 669-1339 (JP)**

(74) Representative: **Hoffmann Eitle
Patent- und Rechtsanwälte PartmbB
Arabellastraße 30
81925 München (DE)**

(56) References cited:
WO-A1-2013/031381     JP-A- 2010 116 580
JP-A- 2012 031 508     JP-A- 2012 229 453
US-A1- 2005 279 630     US-A1- 2010 116 341
US-B1- 6 793 784

**Description**

TECHNICAL FIELD

The present invention relates to a Cu-Ga alloy sputtering target used for the formation of a light-absorbing layer in a compound semiconductor and relates to a sputtering target which reduces cracking and is made of a Cu-Ga alloy and a method for manufacturing the same.

BACKGROUND ART

In recent years, a thin film solar cell manufactured using a compound semiconductor has been put into practical use. In this thin film solar cell, generally, a Mo electrode layer serving as a positive electrode is formed on a soda-lime glass substrate, a light-absorbing layer made of a Cu-In-Ga-Se thin film is formed on the Mo electrode layer, a buffer layer made of ZnS, CdS, or the like is formed on the light-absorbing layer, and a transparent electrode layer serving as a negative electrode is formed on the buffer layer.

In a method for forming the light-absorbing layer made of a Cu-In-Ga-Se thin film, instead of a deposition method in which the film-forming rate is slow and a high cost is required, a method for forming the Cu-In-Ga-Se thin film using a sputtering method is employed.

As the method for forming the Cu-In-Ga-Se thin film using a sputtering method, a method in which a Cu-Ga alloy film is formed through sputtering using a Cu-Ga sputtering target, a laminate film is formed through sputtering on the Cu-Ga alloy film using an In sputtering target, and then the laminate film is thermally treated in a Se atmosphere, thereby forming a Cu-In-Ga-Se thin film is employed. As the Cu-Ga alloy sputtering target, a target made of a Cu-Ga alloy containing 1% by weight to 40% by weight of Ga with the remainder being Cu is known.

As a method for manufacturing the Cu-Ga alloy sputtering target, a powder sintering method such as hot pressing and a casting method such as a vacuum melting method are used. Examples of the Cu-Ga alloy sputtering target manufactured using the powder sintering method include a Cu-Ga alloy sputtering target manufactured using the hot pressing method, but this sputtering target has disadvantages of a high concentration of oxygen and a slow sputter rate while having a fine structure.

In contrast, the Cu-Ga alloy sputtering target manufactured using the casting method has advantages of a low concentration of oxygen and a high sputter rate. However, on the other hand, an ingot made of a Cu-Ga alloy manufactured using the casting method does not have a fine structure, easily segregates, and easily cracks. When the concentration of Ga in the Cu-Ga alloy is 25% by mass or higher, brittleness is high, and there is a significantly high possibility of cracking, and thus it is particularly difficult to carry out plastic processing such as rolling.

The Cu-Ga alloy sputtering target that has been described so far, mainly, has a flat-plate shape and is mounted in a flat plate-type magnetron sputtering device to form a Cu-Ga alloy film. Meanwhile, due to a higher film-forming rate and an extremely higher target usage efficiency compared with the flat plate-type magnetron sputtering device, a cylindrical sputtering target, which is mounted in a rotating cathode-type magnetron sputtering device, is being developed (for example, refer to Patent Documents 1 to 3).

In the rotating cathode-type magnetron sputtering device, a cylindrical sputtering target is mounted in the device as a cathode. In addition, a magnetic field-generating device is installed inside the sputtering target, and sputtering is carried out while rotating the sputtering target. In the rotating cathode-type magnetron sputtering device, the entire surface of a cylindrical sputtering target material is sputtered and is uniformly peeled off, and thus an extremely higher sputtering target usage efficiency compared with the sputtering target usage efficiency of the flat plate-type magnetron sputtering device of the related art can be obtained. Furthermore, in the rotating cathodes-type magnetron sputtering device, since the cooling efficiency improves, compared with the flat plate-type magnetron sputtering device of the related art, there are advantages that it is possible to inject greater power per unit area and a high film-forming rate can be obtained. Since a sputtering target used in the above-described rotating cathode-type sputtering device has a cylindrical shape, there is a demand for a manufacturing technique that is totally different from that for the flat plate-type magnetron sputtering device of the related art.

Patent Document 4 relates to a Cu-Ga alloy sputtering target containing 29 to 42.6 at% of Ga, and a remainder being Cu and unavoidable impurities, wherein the average crystal grain size of a sputter front face is 3 mm or less, and a cross section structure of the target is a columnar structure that has grown in a direction from the sputter front face toward a center plane which is parallel to a sputter face.

Patent Document 5 relates to sputtering target tubes and methods of making sputtering target tubes. The methods include a step of forming a metal hollow preform and flow forming the metal hollow preform to form a sputtering target.

Patent Document 6 relates to a Cu-Ga alloy target material and method of manufacturing the same. The Cu-Ga alloy target material contains 10-95 mass% of Ga, with the remainder being Cu and unavoidable impurities. The Cu-Ga alloy phase has a structure having an average particle diameter of 300 $\mu$m or less.

PRIOR ART LITERATURE

Patent Documents

    Patent Document 1: Japanese Unexamined Patent Application, First Publication No. S55-50958
    Patent Document 2: European Patent No. 1097766
    Patent Document 3: United States Patent No. 6793784
    Patent Document 4: WO 2013/031381 A1 (same patent family as US 2014/001039 A1)
    Patent Document 5: US 2005/279630 A1
    Patent Document 6: JP 2012 031508 A

DISCLOSURE OF INVENTION

Technical Problem

In recent years, as a thin film solar cell manufactured using a compound semiconductor has been put into practical use, there has been a demand for an increase in the size of the thin film solar cell. In response to an increase in the size of the thin film solar cell, the length of a cylindrical sputtering target in the axis direction has increased, and the degree of thermal expansion in the longitudinal direction of the cylindrical sputtering target has become extremely large. Therefore, there has been a problem in that cracking is likely to occur due to the application of heat during bonding or the like.

Therefore, an object of the present invention is to provide a Cu-Ga alloy cylindrical sputtering target which is formed using a simple forming method and prevents cracking.

Solution to Problem

It is known that, generally, in a case in which a molten metal of an alloy is solidified in a fixed casting mold, the solidified structure is not uniform. That is, in a portion in contact with the wall of the casting mold, the molten metal is easily quenched, and the solidification rate is great, and thus chill grains, which form a solidified structure having a small crystal grain size, are generated. After that, columnar crystals are generated along the temperature gradient between the vicinity of the casting mold wall and the inside. When the entire temperature lowers, and the temperature gradient in the solid-liquid interface decreases, due to the decreased temperature gradient which is the driving force for the formation of the columnar crystals, a granular crystal band is generated. It is known that these granular crystals are generated not only by the generation of crystal nuclei in a supercooling region, but also by the fact that some of dendritic crystals generated during the formation of the chill crystals or the formation of the columnar crystals are bent or fusion-cut due to the flow of liquid or other causes, are thus suspended in a liquid phase, and grow again while decreasing the temperature thereof. As described above, when a molten metal is simply solidified in a casting mold, the solidified structure includes chill crystals, a columnar crystal band, and a granular crystal band and is not uniform.

Meanwhile, when a cylindrical sputtering target is formed using a centrifugal casting method as described in Patent Documents 1 to 3, similar to a case in which a cylindrical sputtering target is formed using a fixed casting mold, the solidified structure in the cylindrical sputtering target includes a columnar crystal band. However, this columnar crystal has a coefficient of thermal expansion which varies depending on directions. Therefore, the accumulation of strain caused by thermal stress and the anisotropic strength of the columnar structure make the target become easily cracked.

Therefore, the present inventors paid attention to the fact that, in order to reduce the cracking of a Cu-Ga alloy cylindrical sputtering target, a small fraction of a columnar crystal band in the target structure is important. That is, it was found that it is effective for the reduction of cracking to have a solidified structure made up of granular crystals having a coefficient of thermal expansion which does not vary depending on directions as the solidified structure of the Cu-Ga alloy cylindrical sputtering target. In addition, particularly, it was found that, when the centrifugal casting method or a continuous casting method in which a cylindrical casting mold is used is employed under predetermined conditions, granular crystals are formed in the structure of the Cu-Ca alloy cylindrical sputtering target.

Therefore, the present invention has been obtained on the basis of the above-described finding and employs the following constitutions in order to solve the above-described problems.

In particular, the above-described problems are solved by the cylindrical sputtering target and the method for manufacturing the same as defined in the attached independent claims. Specific embodiments of the invention are identified in the attached dependent claims.

Advantageous Effects of Invention

According to the Cu alloy (Cu-Ga alloy) cylindrical sputtering target of the present invention having the above-described constitution, the solidified structure of the Cu-Ga alloy is made up of granular crystal grains and does not include columnar crystals. Therefore, during the sputtering film formation, the coefficients of thermal expansion of the Cu-Ga alloy cylindrical sputtering target in three directions (X, Y, and Z directions) do not significantly differ. In addition, in the Cu-Ga alloy cylindrical sputtering target, the segregation of Ga is prevented. Therefore, the Cu-Ga alloy cylindrical sputtering target of the present invention is capable of reducing cracking during the sputtering film formation, decreases the manufacturing cost of a compound thin film solar cell, and contributes to the improvement in productivity.

BRIEF DESCRIPTION OF THE DRAWINGS

FIG. 1 is a vertical sectional view describing the outline of a forming device using a transverse-mounted centrifugal casting method for forming a Cu-Ga alloy cylindrical sputtering target of the present invention.
FIG. 2 is a vertical sectional view describing the outline of a forming device using a continuous casting method for forming the Cu-Ga alloy cylindrical sputtering target of the present invention.
FIG. 3 is a view describing a circular section, a vertical section, and a sputtering surface of the Cu-Ga alloy cylindrical sputtering target.
FIG. 4 illustrates photographs of the vertical section and the sputtering surface of a Cu-Ga alloy cylindrical sputtering target manufactured using the transverse-mounted centrifugal casting method.
FIG. 5 is a view describing the ratio (aspect ratio) of the long axis to the short axis of a crystal grain in the Cu-Ga alloy cylindrical sputtering target.
FIG. 6 is a view describing the measurement positions of the film thickness distribution and the Ga composition distribution of a film formed through sputtering using the Cu-Ga alloy cylindrical sputtering target.
FIG. 7 illustrates photographs of a vertical section and a sputtering surface of the Cu-Ga alloy cylindrical sputtering target manufactured using the continuous casting method.

BEST MODE FOR CARRYING OUT THE INVENTION

Hereinafter, an embodiment of the present invention will be described in detail.
In the present embodiment, a Cu-Ga alloy cylindrical sputtering target is formed using a casting method in which a cylindrical casting mold is used. The reasons for employing the casting method are that the Cu-Ga alloy cylindrical sputtering target can be easily formed, and the length in the axial direction can also be easily selected and can be formed to be long, and thus it is possible to easily cope with an increase in the area of a thin film to be formed. It has been found that, as the casting method, a centrifugal casting method and a continuous casting method can be employed.

(In the case of employing centrifugal casting method in which cylindrical casting mold is used)

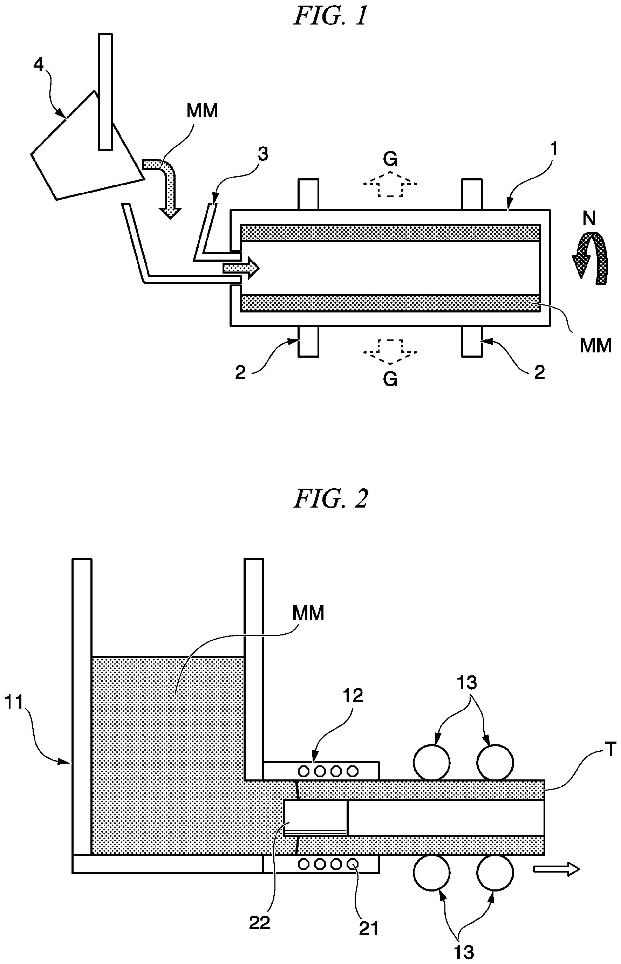

The outline of a device for forming the Cu-Ga alloy cylindrical sputtering target in which the centrifugal casting method is employed is illustrated in FIG. 1. FIG. 1 illustrates a vertical sectional view of the forming device.
This forming device is provided with a casting mold 1 for centrifugal casting that is rotatably supported by a plurality of rollers 2. The casting mold 1 is rotated in, for example, a direction indicated by a reference sign N. A molten metal injection opening 3 is prepared at one end of the casting mold 1, a molten metal MM of a Cu-Ga alloy is supplied to the injection opening 3 from a ladle 4, and is made to flow into the casting mold.
Here, in a case in which a Cu-Ga alloy cylindrical sputtering target is formed using the above-described forming device and a method of the related art, the formed cylindrical sputtering target has a solidified structure including columnar crystals of the Cu-Ga alloy. That is, when the casting mold 1 is rotated at a high rate, a centrifugal force generated by the rotation of the casting mold is exerted on the molten metal MM, and the molten metal falls into a state of being attached to the wall surface of the casting mold. Therefore, similar to the above-described case in which a fixed casting mold is used, a temperature gradient is generated from outside toward inside, and, when the molten metal MM is cooled and solidified, mainly, columnar crystals are formed in the solidified structure, and the solidified structure is not made up of granular crystals.
Therefore, in the present embodiment, in order to obtain a solidified structure not including columnar crystals which cause cracking of the target, it has been determined that the Cu-Ga alloy cylindrical sputtering target made up of granular crystal grains of the Cu-Ga alloy is formed using a forming device in which a transverse-mounted centrifugal casting method is employed.

<Order for forming sputtering target>

First, a Cu-Ga alloy having a predetermined composition is melted at a temperature in a range of 1000°C to 1400°C in a melting furnace, thereby obtaining a molten metal of the Cu-Ga alloy. This molten metal is moved to the ladle and is made to flow into the rotating casting mold while the temperature of the molten metal is lowered from 1300°C to 950°C. At this time, the preheated temperature of the casting mold is in a range of 500°C to 100°C.

The amount of the molten metal injected may be set in a range of approximately 1/7 to 1/20 of the amount of the molten metal being cast per second. At this time, the rotation rate is desirably set in accordance with the diameter of a cast metal so that the relative centrifugal force G reaches 50 times to 150 times the force of gravity. Here, the relative centrifugal force G refers to a value indicating how many times the force of gravity the centrifugal force applied to a subject is, and, in a case in which the rotation rate is indicated by N, and the rotation radius of the casting mold is indicated by r, the relative centrifugal force is expressed by formula (1) described below.

$$\text{Relative centrifugal force } G = 1.118 \times 10^{-5} \times N^2 \times r \qquad (1)$$

While made to flow into the rotating casting mold as it is, the molten metal is cooled at a cooling rate in a range of approximately 1°C/s to 10°C/s, and, when solidification is completed, a cylindrical target material is ejected from the casting mold. The casting surface portion of the cast target material is removed, and the target material is machined to predetermined sizes, thereby producing a Cu-Ga alloy cylindrical sputtering target.

<Conditions for forming granular crystal grain structure>

• Casting temperature (pouring temperature)

In a case in which the temperature of the molten metal exceeds 1300°C, the time taken for the molten metal to be solidified becomes long, and Ga is significantly segregated due to the centrifugal force. In addition, crystal grains are likely to grow in the temperature gradient direction of cooling. On the contrary, when the temperature thereof is lower than 950°C, the time taken for the molten metal to be solidified becomes short, and the surface became already solidified even before the inflow of the subsequent molten metal, and thus a lamellar structure is formed, and the target material becomes brittle. Therefore, the temperature of the molten metal is preferably in a range of 1300°C to 950°C, and more preferably in a range of 1050°C to 1250°C.

• Rotation rate of centrifugal casting

In a case in which the relative centrifugal force is 200 times the force of gravity, the relative centrifugal force (G indicated in FIG. 1) becomes extremely great, and thus, in the Cu-Ga alloy, Cu and Ga are separated from each other and are segregated. In addition, when the relative centrifugal force is smaller than 200 times the force of gravity, even in a case in which the relative centrifugal force is in a range of more than 150 times to less than 200 times the force of gravity, columnar crystals are likely to be generated.

In a case in which the relative centrifugal force is less than 50 times the force of gravity, the relative centrifugal force G becomes low, the removal of impurities becomes difficult, additionally, the molten metal is not tightly attached to the side face of the casting mold, and casting becomes difficult due to poor molding or the like. Therefore, the relative centrifugal force is preferably in a range of 50 times to 150 times the force of gravity and more preferably in a range of 75 times to 130 times the force of gravity.

• Molten metal injection rate

When the amount of the molten metal injected per unit time (molten metal injection rate) is controlled by changing the pipe inner diameter of the molten metal injection opening, and the molten metal is slowly poured in, the development of columnar crystals can be suppressed. At this time, when the molten metal injection rate is appropriate, the molten metal is slowly poured into the casting mold, and thus the growth of crystal grains extending from the wall surface of the casting mold is suppressed, and the growth of columnar crystals is suppressed. When the rotation of the casting mold and the molten metal injection amount are appropriately adjusted, in spite of the generation of columnar crystals, some of dendritic crystals are bent or fusion-cut due to the flow of liquid and the like and serve as nuclei, and the generation of granular grains is accelerated by using the nuclei.

In addition, in a case in which the molten metal injection rate is fast, the excessively-supplied molten metal delays cooling, and the presence of the molten liquid when crystals grow from the wall face of the casting mold encourages unidirectional solidification, and thus columnar crystals are likely to be generated. On the other hand, in a case in which the molten metal injection rate is slow, the molten metal is supplied in a delayed manner, a lamellar structure is formed, and a target material becomes brittle.

Therefore, the molten metal injection rate is preferably in a range of approximately 1/7 to 1/20 of the amount of the molten metal being cast per second and more preferably in a range of approximately 1/10 to 1/18 of the amount of the molten metal being cast per second.

• Preheated temperature of casting mold

When the preheated temperature of the casting mold exceeds 500°C, the casting mold is violently damaged, which causes the failure of the forming device. In addition, during the casting of the molten metal, there is a concern that a mold release agent may be likely to separate out and mix into the cast metal.

On the other hand, when the preheated temperature is lower than 100°C, the inflow of the molten metal into the casting mold deteriorates, and casting defects are generated.

Therefore, the preheated temperature of the casting mold is preferably in a range of 500°C to 100°C, and more preferably in a range of 200°C to 400°C.

• Cooling rate

When the cooling rate is 50°C/s or greater, cracking occurs on the surface of the cast target material. In addition, when the rate is 0.5°C/s or lower, crystal grains coarsen, and structures extending in a needle shape from the wall surface of the casting mold toward the center, that is, columnar crystal grains are generated. That is, the cooling rate can be assumed to be greater than 0.5°C/s and less than 50°C/s and is more preferably in a range of 1°C/s to 10°C/s.

As a specific cooling method, for example, the molten metal is cast in a casting mold preheated to 200°C and is air-cooled for 10 minutes while keeping the casting mold rolling. At this time, the temperature reaches approximately 400°C. After that, the cast metal is ejected from the casting mold and is air-cooled as it is to normal temperature (for example, 25°C to 30°C).

(In the case of employing continuous casting method in which cylindrical casting mold is used)

In the present embodiment, in order to obtain a solidified structure not including columnar crystals which cause cracking of the target, it is also possible to form a Cu-Ga alloy cylindrical sputtering target made up of the granular crystal grains of the Cu-Ga alloy is formed using a forming device in which a continuous casting method is employed.

The outline of the device for forming the Cu-Ga alloy cylindrical sputtering target in which the continuous casting method is employed is illustrated in FIG. 2. FIG. 2 illustrates a vertical sectional view of the forming device.

This forming device is provided with a crucible 11 capable of housing the molten metal MM of the Cu-Ga alloy and a cylindrical casting mold 12 including cooling probes 21. A molten metal injection opening (not illustrated) is provided in the lower portion of the crucible 11, and the molten metal MM is supplied to the casting mold 12 from this injection opening. A cylindrical core cylinder 22 is disposed in the center of the casting mold 12, and the thickness of a cylindrical cast body is determined by the inner diameter of the casting mold 12 and the outer diameter of the cylindrical core cylinder 22. The molten metal MM of the Cu-Ga alloy is supplied to the casting mold 12 from the crucible 11, and is cooled in the casting mold 12, whereby the cylindrical cast body can be obtained. Meanwhile, at the time of the initiation of casting, a cylindrical dummy is inserted into the casting mold, and subsequently, the cylindrical dummy is drawn at a predetermined rate through the rotation of a pinch roller 13, thereby drawing the cylindrical cast body.

<Order for forming sputtering target>

First, a Cu-Ga alloy having a predetermined composition is melted at a temperature in a range of 1000°C to 1300°C in a melting furnace, thereby obtaining a molten metal of the Cu-Ga alloy. A cylindrical cast body is cast at a drawing rate in a range of 10 mm/min to 50 mm/min using the molten metal. The obtained ingot is cut into predetermined sizes and is machined, thereby producing a Cu-Ga alloy cylindrical sputtering target.

<Conditions for forming granular crystal grain structure>

• Holding temperature

In a case in which the temperature of the molten metal exceeds 1300°C, the time taken for the molten metal to be solidified becomes long, and Ga is significantly segregated due to the centrifugal force. In addition, crystal grains are likely to grow in the temperature gradient direction of cooling. On the contrary, when the temperature thereof is lower than 900°C, solidification becomes fast during continuous casting, the deterioration of the flow of the molten metal is likely to generate defects, and, in a worse case, casting becomes impossible. Therefore, the temperature of the molten metal is preferably in a range of 1000°C to 1300°C, and more preferably in a range of 1050°C to 1250°C.

• Drawing rate

In a case in which the drawing rate is less than 10 mm/min, the temperature gradient in the radial direction (from outside to inside of the cylindrical cast body) becomes relatively weak compared with that in the drawing direction, and a columnar structure grows in the drawing direction, and thus the casting rate (drawing rate) is desirably faster than 10 mm/min. At this time, the cooling rate of the ingot has a correlation with the drawing rate, and it is also possible to rapidly cool the ingot by increasing the drawing speed. Therefore, the drawing rate is 10 mm/min or greater, preferably in a range of 10 mm/min to 50 mm/min, and more preferably in a range of 15 mm/min to 40 mm/min.

Next, the components of the Cu-Ga alloy and the shapes of crystal grains relating to the Cu-Ga alloy cylindrical sputtering targets of the present embodiment manufactured using the centrifugal casting method and the continuous casting method will be described below.

<Component composition of Cu-Ga alloy>

The Cu-Ga alloy cylindrical sputtering target of the present embodiment is made of a Cu alloy containing 15 atom% to 35 atom% of Ga. When the content of Ga is less than 15 atom%, the conversion efficiency of a compound thin film solar cell does not increase, and, on the other hand, when the content of Ga exceeds 35 atom%, the strength of the sputtering target decreases, and the sputtering target is likely to crack. The content of Ga is more preferably in a range of 20 atom% to 30 atom%.

In addition, when the Cu-Ga alloy cylindrical sputtering target has a high concentration of oxygen, a Ga oxide is generated and thus abnormal discharge is likely to occur, and additionally, the conversion efficiency of a solar cell does not increase, and thus the concentration of oxygen is set to 50 ppm by mass or lower. Furthermore, the concentration of oxygen may be preferably set to 30 ppm by mass or lower and more preferably set to 20 ppm by mass or lower. Meanwhile, the lower limit value of the concentration of oxygen may be set to 0.01 ppm by mass.

In addition, in the Cu-Ga alloy cylindrical sputtering target, the difference (Ga concentration difference) between the maximum value and the minimum value of the concentration of Ga in a sputtering portion is preferably 2.0 atom% or lower and more preferably in a range of 0 atom% to 1.0 atom%.

The Ga concentration difference is obtained by measuring the concentration of Ga in the sputtering portion, that is, a sputtering surface described below, in the Cu-Ga alloy cylindrical sputtering target at three points in 400 square centimeters using ICP, computing the difference between the maximum value and the minimum value, carrying out the above-described steps three times, and computing the average value thereof.

<Shape of crystal grains>

The Cu-Ga alloy structure of the Cu-Ga alloy cylindrical sputtering target according to the present embodiment will be described. For the suppression of cracking, the Cu-Ga alloy structure is made up of granular crystal grains, and the granular crystal grains can be generated using the above-described centrifugal casting method. In the present embodiment, in the Cu-Ga alloy structure, the average value (aspect ratio: long axis/short axis) of the ratios of a long axis to a short axis of crystal grains is set to 2.0 or lower. At this time, since the value is considered to vary depending on the viewing directions, the axes are desirably observed in a sectional direction of the target and in a direction of the sputtering surface.

In addition, for the prevention of cracking and the reduction of abnormal discharge, the average equivalent circle diameter of the crystal grains projected from a sputtering surface is preferably 5 mm or lower. The average equivalent circle diameter of the crystal grains is more preferably in a range of 0.01 mm to 3 mm.

• Measurement of aspect ratios of crystal grains and average equivalent circle diameter

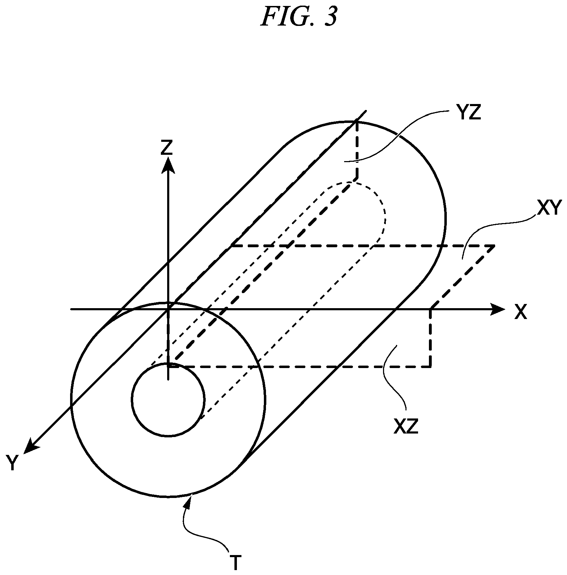

The section of the target in the present embodiment is defined as described below. First, FIG. 3 illustrated the schematic shape of the Cu-Ga alloy cylindrical sputtering target. In FIG. 3, the axial direction of the sputtering target is considered as a Y axis, and the thickness direction thereof is considered as a Z axis. Furthermore, the surface of the sputtering target in the circumferential direction served as the sputtering surface; however, herein, in such a case, the sputtering surface is continuous, and thus, for ease of understanding, the sputtering surface is illustrated so as to spread in an X-axis direction. At this time, in FIG. 3, the XY surface is defined as a surface for observing the sputtering surface, the XZ surface is defined as a surface for observing the circular section, and YZ is defined as a surface for observing the vertical section.

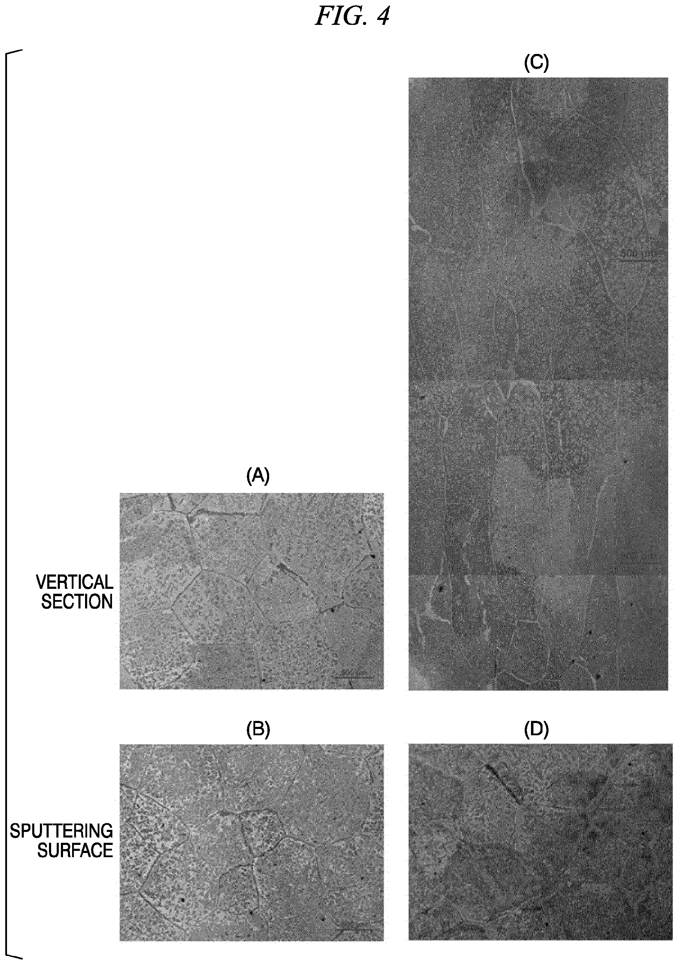

FIG. 4 illustrated the photographs of the vertical section (A) and the sputtering surface (B) in the Cu-Ga alloy cylindrical sputtering target of the present embodiment formed using the above-described centrifugal casting method. In addition, (C) illustrates a vertical section of a sputtering target produced using a method of the related art, and (D) illustrates a sputtering surface thereof. Meanwhile, (C) illustrates a plurality of captured photographs connected together in order to illustrate the Z-axis direction of the vertical surface.

In the capturing of these photographs, first, the formed Cu-Ga alloy cylindrical sputtering target is cut, and surfaces in three directions to be observed are polished. Next, the surfaces are etched by immersing the surfaces in nitric acid as an etchant for approximately two to three minutes, and then the surfaces are washed with water for approximately 30 seconds, thereby forming a state in which crystal grains are easily visible.

As an image for the measurement of each of the sputtering surfaces, the circular section, and the vertical section in three directions, 16 photographs (3.8 mm×2.8 mm) are combined together so as to produce a 15.2 mm×11.2 mm-sized image. Measurement is carried out at three positions in each direction. The profiles of crystal grains in the captured image are scanned using the difference in hue, and the equivalent circle diameters and the average ratios are measured.

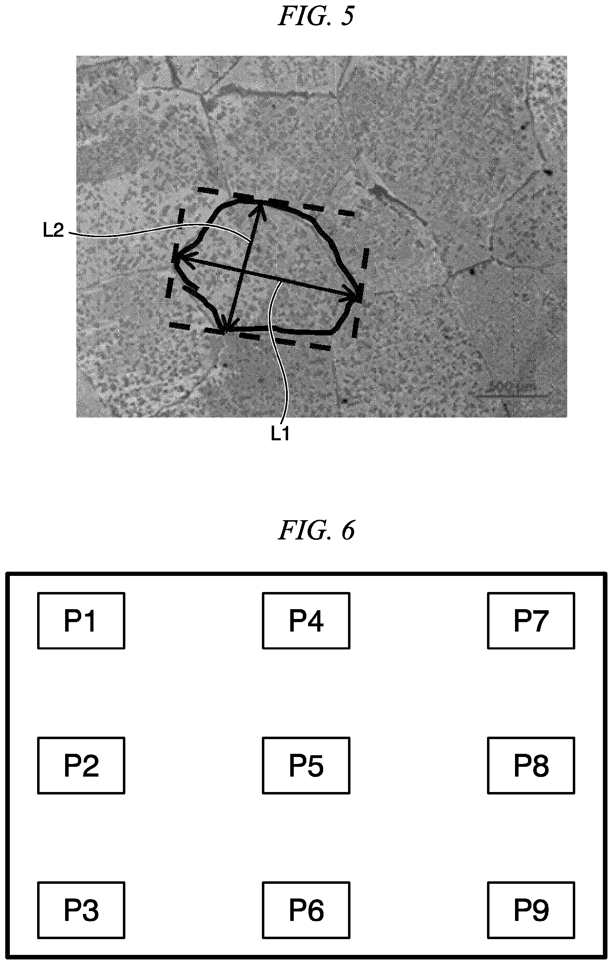

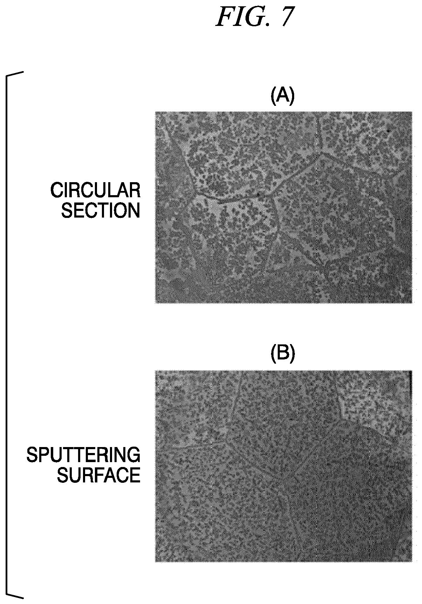

Regarding the aspect ratios of crystal grains, the aspect ratio of each surface of the sputtering surface, the circular section, and the vertical surface is obtained by measuring the absolute maximum lengths (long axes) L1 and the widths (short axes) L2 of the maximum portions of portions orthogonal to the absolute maximum length of individual grains in the observed two-dimensional image as illustrated in FIG. 5, and averaging the measurement values. Meanwhile, the image illustrated in FIG. 5 exemplifies the case of an image of the vertical section (A) in FIG. 4. Furthermore, FIG. 7 illustrates the photographs of the vertical section (A) and the sputtering surface (B) of the Cu-Ga alloy cylindrical sputtering target of the present embodiment formed using the above-described continuous casting method; however, even in this case, the components of the Cu-Ga alloy and the shapes of crystal grains are the same as in the case of the Cu-Ga alloy cylindrical sputtering target formed using the centrifugal casting method.

Therefore, in the present embodiment, crystal grains in the Cu-Ga alloy structure having an aspect ratio (long axis/short axis) of 2.0 or lower are considered as granular crystal grains. Meanwhile, the lower limit value of the aspect ratio is 1.0.

In addition, the areas of the crystal grains are measured on the basis of the respective images of the sputtering surface, the circular section, and the vertical section obtained above, and the equivalent circle diameters of the crystal grains are computed. When the area is indicated by S, and the equivalent circle diameter of the crystal grain is indicated by R, the equivalent circle diameter R is obtained using a formula of $R=2(S/\pi)^{\frac{1}{2}}$. In the present embodiment, for the crystal grains in the Cu-Ga alloy structure, the average equivalent circle diameter of the crystal grains projected from the sputtering surface is set to 5 mm or lower. The average equivalent circle diameter is more preferably in a range of 0.01 mm to 3 mm.

<Target thickness>

The target thickness (the thickness of the cylindrical shape in the Z direction) of the Cu-Ga alloy cylindrical sputtering target of the embodiment is desirably 3 mm or greater, and more desirably in a range of 5 mm to 13 mm. The target thickness can be measured using a caliper.

EXAMPLES

Next, the Cu-Ga alloy cylindrical sputtering target of the present invention will be specifically described using examples.

[Examples]

First, a Cu-Ga alloy having a concentration of Ga shown in Table 1 was melted in a melting furnace, thereby obtaining a molten metal of the Cu-Ga alloy. This molten metal was moved to a ladle and was made to flow into a rotating casting mold in accordance with the target manufacturing conditions shown in Table 1. At this time, the preheated temperature of the casting mold was 200°C.

The amount of the molten metal injected was set to 1/10 of the amount of the molten metal being cast per second. At this time, the rotation rate was adjusted in accordance with the diameter of a cast metal so that the relative centrifugal force shown in Table 1 was obtained. While being made to flow into the rotating casting mold as it was, the molten metal was cooled, and, when solidification was completed, a cylindrical target material was ejected from the casting mold. The cooling rate shown in the table is an average value obtained by dividing the difference between the casting temperature and the removal temperature by the necessary time. The surface of this target material was cut and flattened, and a backing plate was bonded to the inner circumferential surface in the central portion, thereby producing a Cu-Ga alloy cylindrical sputtering target of each of Examples 1 to 10 using the centrifugal casting method.

Meanwhile, in Comparative Example 10, 5 atom% of Bi is added and, in Comparative Example 11, 5 atom% of Sb is added.

In addition, the Cu-Ga alloy cylindrical sputtering targets of Examples 13 to 15 were produced using the continuous casting method.

[Comparative Example]

In addition, for comparison with the examples, Cu-Ga alloy cylindrical sputtering targets of Comparative Examples 1 to 9 were produced. Here, in Comparative Examples 1 and 3, sputtering targets were produced using a mold casting method and, in Comparative Example 2, a sputtering target was produced using a powder sintered product. In Comparative Examples 4 to 8, sputtering targets having a concentration of Ga outside the range of the present invention were prepared or sputtering targets were manufactured under target manufacturing conditions outside the range of the present invention. Comparative Example 9 is a case in which a sputtering target was produced using the continuous casting method, but the target manufacturing conditions were outside the range of the present invention.

[Table 1]

| | | Concentration of Ga (atom%) | Content of O (ppm by mass) | Target manufacturing conditions | | | |
|---|---|---|---|---|---|---|---|
| | | | | Casting temperature (°C) | Cooling rate (°C/s) | Relative centrifugal force (G) | Drawing rate (mm/min) |
| | Example 1 | 25.0 | 15 | 1050 | 1.0 | 110 | |
| | Example 2 | 25.0 | 16 | 1050 | 1.0 | 110 | |
| | Example 3 | 25.0 | 35 | 1150 | 1.0 | 110 | |
| | Example 4 | 25.0 | 25 | 1100 | $5.0 \times 10^{-1}$ | 110 | |
| | Example 5 | 25.0 | 30 | 1100 | 1.0 | 150 | |
| | Example 6 | 25.0 | 40 | 1050 | 1.0 | 60 | |
| | Example 7 | 35.0 | 16 | 1050 | 1.0 | 110 | |
| | Example 8 | 30.0 | 14 | 1050 | 1.0 | 110 | |
| | Example 9 | 27.5 | 15 | 1050 | 1.0 | 110 | |
| | Example 10 | 15.0 | 15 | 1050 | 1.0 | 110 | |
| | Comparative Example 10 | 25.0 | 4 | 1050 | 1.0 | 110 | |
| | Comparative Example 11 | 25.0 | 15 | 1050 | 1.0 | 110 | |
| | Example 13 | 25.0 | 10 | 1050 | | | 10 |
| | Example 14 | 25.0 | 14 | 1050 | | | 10 |
| | Example 15 | 25.0 | 20 | 1050 | | | 50 |
| | Comparative Example 1 | 25.0 | 10 | 1050 | 0.5 | | |

(continued)

| | Concentration of Ga (atom%) | Content of O (ppm by mass) | Target manufacturing conditions | | | |
|---|---|---|---|---|---|---|
| | | | Casting temperature (°C) | Cooling rate (°C/s) | Relative centrifugal force (G) | Drawing rate (mm/min) |
| Comparative Example 2 | 25.0 | 58 | Powder sintered product | | | |
| Comparative Example 3 | 25.0 | 13 | 1050 | 1.0 | | |
| Comparative Example 4 | 25.0 | 40 | 1040 | $1.0 \times 10^{-1}$ | 110 | |
| Comparative Example 5 | 25.0 | 15 | 1050 | 1.0 | 200 | |
| Comparative Example 6 | 40.0 | 18 | 1050 | 1.0 | 110 | |
| Comparative Example 7 | 10.0 | 19 | 1050 | 1.0 | 110 | |
| Comparative Example 8 | 25.0 | 15 | 1050 | 1.0 | 30 | |
| Comparative Example 9 | 25.0 | - | 900 | - | - | - |

Next, for the Cu-Ga alloy cylindrical sputtering targets of Examples 1 to 15 and Comparative Examples 1 to 8, the aspect ratios of the sputtering surfaces, the circular sections, and the vertical sections, the target thicknesses, the average equivalent circle diameters of crystal grains projected from the sputtering surfaces, and the difference in the concentration of Ga (the difference between the maximum value and the minimum value) were measured using the above-described measurement methods. The measurement results are shown in Table 2 below. Meanwhile, the analysis results relating to the contents of oxygen (O) in the targets are shown in Table 1. In addition, in the case of Comparative Example 8, the target thickness was not measured due to poor molding. In the case of Comparative Example 9, since molding was not possible, the crystal grain aspect ratio, the target thickness, the average equivalent circle diameter, and the difference in the concentration of Ga were not measured.

[Table 2]

| | Crystal grain aspect ratio (average value) | | | Thickness (mm) | Average equivalent circle diameter (mm) | Difference in concentration of Ga (atom%) |
|---|---|---|---|---|---|---|
| | Sputtering surface | Circular section | Vertical section | | | |
| Example 1 | 1.38 | 1.44 | 1.45 | 4 | 0.96 | 0.4 |
| Example 2 | 1.40 | 1.42 | 1.33 | 13 | 1.13 | 0.5 |
| Example 3 | 1.48 | 1.89 | 1.84 | 13 | 1.31 | 0.4 |
| Example 4 | 1.43 | 1.76 | 1.81 | 13 | 2.73 | 0.6 |
| Example 5 | 1.48 | 1.90 | 1.87 | 13 | 1.22 | 1.2 |
| Example 6 | 1.54 | 1.48 | 1.47 | 13 | 1.34 | 0.3 |
| Example 7 | 1.38 | 1.41 | 1.39 | 13 | 1.37 | 0.3 |
| Example 8 | 1.48 | 1.23 | 1.34 | 13 | 2.11 | 0.4 |
| Example 9 | 1.42 | 1.52 | 1.46 | 13 | 1.97 | 0.5 |
| Example 10 | 1.32 | 1.35 | 1.44 | 13 | 1.57 | 0.7 |

(continued)

| | Crystal grain aspect ratio (average value) | | | Thickness (mm) | Average equivalent circle diameter (mm) | Difference in concentration of Ga (atom%) |
|---|---|---|---|---|---|---|
| | Sputtering surface | Circular section | Vertical section | | | |
| Comparative Example 10 | 1.42 | 1.43 | 1.51 | 13 | 1.63 | 0.5 |
| Comparative Example 11 | 1.33 | 1.45 | 1.43 | 13 | 1.70 | 0.5 |
| Example 13 | 1.61 | 1.28 | 1.56 | 10 | 2.41 | 0.7 |
| Example 14 | 1.48 | 1.33 | 1.51 | 10 | 2.15 | 0.5 |
| Example 15 | 1.37 | 1.53 | 1.34 | 10 | 1.58 | 0.3 |
| Comparative Example 1 | 1.35 | 4.22 | 3.12 | 13 | 2.65 | 0.5 |
| Comparative Example 2 | 1.28 | 1.32 | 1.33 | 13 | 0.66 | 0.6 |
| Comparative Example 3 | 1.32 | 2.41 | 2.13 | 2 | 1.31 | 0.5 |
| Comparative Example 4 | 1.34 | 2.87 | 2.64 | 13 | 5.12 | 0.6 |
| Comparative Example 5 | 1.42 | 3.75 | 4.12 | 13 | 1.21 | 2.6 |
| Comparative Example 6 | 1.55 | 1.61 | 1.53 | 13 | 1.54 | 0.5 |
| Comparative Example 7 | 1.45 | 1.48 | 1.38 | 13 | 1.67 | 2.2 |
| Comparative Example 8 | 1.46 | 1.49 | 1.42 | Poor molding | 1.67 | 0.7 |
| Comparative Example 9 | Poor molding | | | | | |

Furthermore, for each of the Cu-Ga alloy cylindrical sputtering targets of Examples 1 to 15 and Comparative Examples 1 to 8, the presence or absence of of cracking during the bonding was observed. The results are shown in Table 3 below.

Next, Cu-Ga alloy thin films were formed through sputtering using the Cu-Ga alloy cylindrical sputtering targets of Examples 1 to 15 and Comparative Examples 1 to 8. The sputtering film formation was carried out under the following conditions.

- Substrate: a glass substrate
- Power supply: DC 12.5 kW/m
- Gas pressure during film formation: 0.40 Pa
- Amount of Ar introduced: 500 sccm

For the formed thin films, the film thickness distribution, the in-film compositions (the distribution of Ga), and the number of times of abnormal discharge were evaluated. The evaluation results are shown in Table 3. Here, for the number of times of abnormal discharge, the number of instances of electric arcs during one-hour discharge was measured.

Meanwhile, the film thickness distribution and the compositional distribution of Ga were obtained by selecting a specific region and carrying out measurements at nine points of P1 to P9 in the region as illustrated in FIG. 6.

On the basis of these measurement values at nine points, evaluation values were computed using (maximum value-minimum value)/average value/2×100, and, regarding the film thickness distribution, evaluation values of 10% or more were marked as "C", evaluation values in a range of 10% to 8% were marked as "B", and evaluation values of 8% or lower are marked as "A". In addition, regarding the distribution of Ga, using the same method, evaluation values of 4% or more were marked as "C", evaluation values in a range of 4% to 2% were marked as "B", and evaluation values of 2% or lower are marked as "A".

[Table 3]

| | Film thickness distribution | In-film composition (distribution of Ga) | Number of times of abnormal discharge | Occurrence of cracking during bonding |
|---|---|---|---|---|
| Example 1 | A | A | 1 | No cracking |
| Example 2 | A | A | 25 | No cracking |
| Example 3 | A | A | 78 | No cracking |
| Example 4 | B | A | 15 | No cracking |
| Example 5 | A | B | 65 | No cracking |
| Example 6 | A | A | 95 | No cracking |
| Example 7 | A | A | 4 | No cracking |
| Example 8 | A | A | 3 | No cracking |
| Example 9 | A | A | 2 | No cracking |
| Example 10 | A | A | 4 | No cracking |
| Comparative Example 10 | A | A | 17 | No cracking |
| Comparative Example 11 | A | A | 18 | No cracking |
| Example 13 | A | A | 18 | No cracking |
| Example 14 | A | A | 19 | No cracking |
| Example 15 | A | A | 5 | No cracking |
| Comparative Example 1 | | | | Cracking |
| Comparative Example 2 | B | B | 747 | No cracking |
| Comparative Example 3 | | | | Cracking |
| Comparative Example 4 | | | | Cracking |
| Comparative Example 5 | | | | Cracking |
| Comparative Example 6 | | | | Cracking |
| Comparative Example 7 | B | C | 2 | No cracking |
| Comparative Example 8 | Poor molding | | | |
| Comparative Example 9 | Poor molding | | | |

According to the results shown above, it was confirmed that, in the Cu-Ga alloy cylindrical sputtering targets of Examples 1 to 15, granular crystal grains were generated in the structures of the Cu-Ga alloys, and cracking did not occur during the bonding in all of the Cu-Ga alloy cylindrical sputtering targets. In addition, the numbers of times of abnormal discharge during the sputtering did not exceed 100 times, furthermore, the differences in the concentration of Ga (the difference between the maximum value and the minimum value in the measurement region) in the formed Cu-Ga films were small, and the film thickness distributions were also favorable.

In contrast, in Comparative Example 1, since the aspect ratios were great, particularly, in the circular section and the vertical section, and the coefficient of thermal expansion became large in a single direction, cracking occurred during the bonding, and it was not possible to produce a sputtering target. In Comparative Example 2, cracking during the bonding was not observed, but the content of O was high, and abnormal discharge frequently occurred during the sputtering. In Comparative Example 3, the puttering target was thin, cracking occurred, and the target was not suitable for sputtering. In Comparative Example 4, since crystal grains and the aspect ratios were large, cracking occurred during the bonding, and it was not possible to produce a sputtering target. In Comparative Example 5, since the centrifugal force was great during the centrifugal casting, the aspect ratios became large in the circular section and the vertical section, it was not possible to form desired granular crystals, and cracking occurred during the bonding. In Comparative Example 6, it was possible to form desired granular crystals, but the concentration of Ga was too high, thus, cracking occurred during the bonding, and it was not possible to produce a sputtering target. In Comparative Example 7, since the concentration of Ga was too low, while it was possible to form desired granular crystals, the difference in the concentration of Ga was large, and the composition of the formed film was influenced. Furthermore, in Comparative Example 8, since the centrifugal force was too small during the centrifugal casting, molding became poor, and it was not possible to produce a sputtering target that could be used to form a film. In addition, in the case of Comparative Example 9, since the melting temperature was too low, it was not possible to produce a sputtering target using the continuous casting method.

As described above, it was confirmed that, in order to reduce cracking in the Cu-Ga alloy cylindrical sputtering targets according to the examples, a small fraction of a columnar crystal band in the target structure is important, and it is effective for the reduction of cracking to have a solidified structure made up of granular crystals having a coefficient of thermal expansion which does not vary in the Cu-Ga alloy cylindrical sputtering target. In addition, particularly, it was also confirmed that, when the centrifugal casting method is employed under predetermined conditions, granular crystals are formed in the structure of the Cu-Ga alloy cylindrical sputtering target. Furthermore, as long as the content of Ga is within the above-described range, even when Zn, Sb, Al, Li, Bi, P, Sn, In, Na, S, Se, F, Ag, Si, Be, Mg, Mn, and Mo are added to the present invention in a total of 5% by mass or less, the crystal grain shape which is the characteristic of the present invention can be obtained, and thus it is possible to produce a target in which cracking rarely occurs by applying the present invention.

INDUSTRIAL APPLICABILITY

The Cu-Ga alloy cylindrical sputtering target of the present invention is a cylindrical sputtering target which reduces cracking during sputtering and can be used for the formation of a light-absorbing layer in a compound semiconductor.

REFERENCE SIGNS LIST

1    CASTING MOLD FOR CENTRIFUGAL CASTING
2    ROTATABLY-SUPPORTING ROLLER
3    MOLTEN METAL INJECTION OPENING
4    MOLTEN METAL LADLE
11   CRUCIBLE FOR CONTINUOUS CASTING
12   CYLINDRICAL CASTING MOLD
13   PINCH ROLLER
MM   MOLTEN METAL
T    CYLINDRICAL CAST BODY

Claims

1. A cylindrical sputtering target formed through casting, wherein,

the cylindrical sputtering target is a Cu alloy consisting of 15 atom% to 35 atom% of Ga, optionally Zn, Sb, Al, Li, Bi, P, Sn, In, Na, S, Se, F, Ag, Si, Be, Mg, Mn, and Mo in a total of 5% by mass or less, optionally 50 ppm by mass or lower oxygen and balance Cu,

the Cu alloy has a solidified structure made up of granular crystal grains and does not include columnar crystals, and

the average value of the ratios of the long axes to the short axes of the granular crystal grains in the Cu alloy is 2.0 or lower, wherein the average value is determined as defined in the section "Measurement of aspect ratios of crystal grains and average equivalent circle diameter" of the description.

2. The cylindrical sputtering target according to Claim 1,
wherein the thickness of the target is 3 mm or greater.

3. The cylindrical sputtering target according to Claim 1 or 2,
wherein the average equivalent circle diameter of the granular crystal grains projected from a sputtering surface, which is the surface of the sputtering target in the circumferential direction, is 5 mm or lower, wherein the equivalent circle diameter is defined as $R = 2(S/\pi)^{1/2}$, wherein S indicates the area of the crystal grains and is determined as defined in the section "Measurement of aspect ratios of crystal grains and average equivalent circle diameter" of the description.

4. The cylindrical sputtering target according to any one of Claims 1 to 3,
wherein the difference between the maximum value and the minimum value of the concentration of Ga in a sputtering surface is 2.0 atom% or lower, wherein the difference is determined as defined in the section "Component composition of Cu-Ga alloy" of the description.

5. A method for manufacturing the cylindrical sputtering target according to any one of Claims 1 to 4, wherein,
the centrifugal force applied to a molten metal of a Cu alloy containing 15 atom% to 35 atom% of Ga is 50 times to 150 times the force of gravity in a centrifugal casting method, and
the cooling rate is greater than 0.5°C/s and less than 50°C/s, wherein the cooling rate is an average value obtained by dividing the difference between the casting temperature of the molten metal and the removal temperature of the cylindrical sputtering target from a casting mold after solidification by the necessary time.

6. A method for manufacturing the cylindrical sputtering target according to any one of Claims 1 to 4,
wherein the molten metal of the Cu alloy containing 15 atom% to 35 atom% of Ga is poured into a cooled cylindrical casting mold and is continuously cast at a drawing rate of 10 mm/min to 50 mm/min, and the temperature of the molten metal is 1000°C to 1300°C.

**Patentansprüche**

1. Zylinderförmiges Sputtertarget, gebildet durch Gießen, wobei
das zylinderförmige Sputtertarget eine Cu-Legierung, bestehend aus 15 Atom-% bis 35 Atom-% Ga, gegebenenfalls Zn, Sb, Al, Li, Bi, P, Sn, In, Na, S, Se, F, Ag, Si, Be, Mg, Mn und Mo zu insgesamt 5 Masse-% oder weniger, gegebenenfalls 50 Masse-ppm oder weniger Sauerstoff und dem Rest Cu,

die Cu-Legierung eine verfestigte Struktur aus granularen Kristallkörnern aufweist und keine säulenförmigen Kristalle einschließt und

der Durchschnittswert der Verhältnisse der langen Achsen zu den kurzen Achsen der granularen Kristallkörner in der Cu-Legierung 2,0 oder niedriger ist, wobei der Durchschnittswert wie im Abschnitt "Messung der Aspektverhältnisse der Kristallkörner und durchschnittlicher äquivalenter Kreisdurchmesser" der Beschreibung definiert bestimmt wird.

2. Zylinderförmiges Sputtertarget gemäß Anspruch 1,
wobei die Dicke des Targets 3 mm oder größer ist.

3. Zylinderförmiges Sputtertarget gemäß Anspruch 1 oder 2,
wobei der durchschnittliche äquivalente Kreisdurchmesser der granularen Kristallkörner, die aus einer Sputteroberfläche hervorstehen, welche die Oberfläche des Sputtertargets in Umfangsrichtung ist, 5 mm oder niedriger ist, wobei der äquivalente Kreisdurchmesser als $R = 2(S/\pi)^{1/2}$ definiert ist, wobei S die Fläche der Kristallkörner angibt und wie im Abschnitt "Messung der Aspektverhältnisse der Kristallkörner und durchschnittlicher äquivalenter Kreisdurchmesser" der Beschreibung definiert bestimmt wird.

**4.** Zylinderförmiges Sputtertarget gemäß irgendeinem der Ansprüche 1 bis 3,
wobei die Differenz zwischen dem Maximalwert und dem Minimalwert der Ga-Konzentration in einer Sputteroberfläche 2,0 Atom-% oder niedriger ist, wobei die Differenz wie im Abschnitt
"Komponentenzusammensetzung der Cu-Ga-Legierung" der Beschreibung definiert bestimmt wird.

**5.** Verfahren zur Herstellung des zylinderförmigen Sputtertargets gemäß irgendeinem der Ansprüche 1 bis 4, wobei die Zentrifugalkraft, die auf ein geschmolzenes Metall aus einer Cu-Legierung, die 15 Atom-% bis 35 Atom-% Ga enthält, ausgeübt wird das 50-fache bis 150-fache der Schwerkraft in einem Schleudergussverfahren beträgt und die Abkühlgeschwindigkeit größer als 0,5°C/s und kleiner als 50°C/s ist, wobei die Abkühlgeschwindigkeit ein Durchschnittswert ist, der durch Dividieren der Differenz zwischen der Gusstemperatur des geschmolzenen Metalls und der Entfernungstemperatur des zylinderförmigen Sputtertargets aus der Gussform nach Verfestigung durch die notwendige Zeit erhalten wird.

**6.** Verfahren zur Herstellung des zylinderförmigen Sputtertargets gemäß irgendeinem der Ansprüche 1 bis 4, wobei das geschmolzene Metall aus der Cu-Legierung, die 15 Atom-% bis 35 Atom-% Ga enthält, in eine gekühlte zylinderförmige Gussform gegossen wird und bei einer Ziehgeschwindigkeit von 10 mm/min bis 50 mm/min stranggegossen wird und die Temperatur des geschmolzenen Metalls 1.000°C bis 1.300°C beträgt.

## Revendications

**1.** Cible de pulvérisation cylindrique formée par coulée, dans laquelle,
la cible de pulvérisation cylindrique est un alliage de Cu consistant en 15 % atomique à 35 % atomique de Ga, facultativement Zn, Sb, Al, Li, Bi, P, Sn, In, Na, S, Se, F, Ag, Si, Be, Mg, Mn, et Mo dans un total de 5 % en masse ou moins, facultativement 50 ppm en masse ou moins d'oxygène et le reste est Cu,
l'alliage de Cu présente une structure solidifiée faite de grains cristallins granulaires et n'inclut pas de cristaux colonnaires, et
la valeur moyenne des rapports des grands axes sur les petits axes des grains cristallins granulaires dans l'alliage de Cu est de 2,0 ou moins, dans laquelle la valeur moyenne est déterminée comme défini dans la section « Mesure des rapports d'aspect des grains cristallins et du diamètre moyen de cercle équivalent » de la description.

**2.** Cible de pulvérisation cylindrique selon la revendication 1,
dans laquelle l'épaisseur de la cible est de 3 mm ou plus.

**3.** Cible de pulvérisation cylindrique selon la revendication 1 ou 2,
dans laquelle le diamètre moyen de cercle équivalent des grains cristallins granulaires projetés depuis une surface de pulvérisation, qui est la surface de la cible de pulvérisation dans la direction circonférentielle, est de 5 mm ou moins, dans laquelle le diamètre de cercle équivalent est défini par $R = 2(S/\pi)^{1/2}$, dans lequel S indique la surface des grains cristallins et est déterminé comme défini dans la section « Mesure des rapports d'aspect des grains cristallins et du diamètre moyen de cercle équivalent » de la description.

**4.** Cible de pulvérisation cylindrique selon l'une quelconque des revendications 1 à 3,
dans laquelle la différence entre la valeur maximale et la valeur minimale de la concentration en Ga dans une surface de pulvérisation est de 2,0 % atomique ou moins, dans laquelle la différence est déterminée comme défini dans la section « Composition en composants de l'alliage de Cu-Ga » de la description.

**5.** Procédé de fabrication de la cible de pulvérisation cylindrique selon l'une quelconque des revendications 1 à 4, dans lequel,
la force centrifuge appliquée à un métal fondu d'un alliage de Cu contenant 15 % atomique à 35 % atomique de Ga est 50 fois à 150 fois la force de gravité dans un procédé de coulée par centrifugation, et
la vitesse de refroidissement est supérieure à 0,5 °C/s et inférieure à 50 °C/s, dans lequel la vitesse de refroidissement est une valeur moyenne obtenue en divisant la différence entre la température de coulée du métal fondu et la température de retrait de la cible de pulvérisation cylindrique à partir d'un moule de coulée après solidification par le temps nécessaire.

**6.** Procédé de fabrication de la cible de pulvérisation cylindrique selon l'une quelconque des revendications 1 à 4,

dans lequel le métal fondu de l'alliage de Cu contenant 15 % atomique à 35 % atomique de Ga est versé dans un moule de coulée cylindrique refroidi et est coulé en continu à un taux d'étirage de 10 mm/min à 50 mm/min, et la température du métal fondu est de 1000 °C à 1 300 °C.

*FIG. 1*

*FIG. 2*

*FIG. 3*

## FIG. 4

(C)

(A)

VERTICAL
SECTION

(B)

SPUTTERING
SURFACE

(D)

*FIG. 5*

*FIG. 6*

*FIG. 7*

(A)

CIRCULAR
SECTION

(B)

SPUTTERING
SURFACE

**EP 2 980 268 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP S5550958 B
- EP 1097766 A
- US 6793784 B
- WO 2013031381 A1
- US 2014001039 A1
- US 2005279630 A1
- JP 2012031508 A